# EUROPÄISCHE PATENTSCHRIFT

(11) **EP 1 514 171 B1**
(45) Veröffentlichungstag und Bekanntmachung des Hinweises auf die Patenterteilung: **02.11.2006**
(21) Anmeldenummer: 03760627.4
(22) Anmeldetag: 17.06.2003
(51) Int. Cl.: G06F 3/06, G06F 12/02

(54) **VERFAHREN ZUR WIEDERHERSTELLUNG VON VERWALTUNGSDATENSÄTZEN EINES BLOCKWEISE LÖSCHBAREN SPEICHERS**
METHOD FOR RESTORING ADMINISTRATIVE DATA RECORDS OF A MEMORY THAT CAN BE ERASED IN BLOCKS
PROCEDE POUR RECUPERER DES ENREGISTREMENTS DE DONNEES ADMINISTRATIVES D'UNE MEMOIRE EFFACABLE PAR BLOCS

(30) Priorität: 19.06.2002 DE 10227255
(43) Veröffentlichungstag der Anmeldung: 16.03.2005
(73) Patentinhaber: Hyperstone AG, 78467 Konstanz (DE)
(72) Erfinder: BAUMHOF, Christoph, 78315 Radolfzell-Güttingen (DE); KÜHNE, Reinhard, 78479 Reichenau (DE)
(74) Vertreter: Hanewinkel, Lorenz
(86) Internationale Anmeldenummer: PCT/EP2003/006355
(87) Internationale Veröffentlichungsnummer: WO 2004/001579

(56) Entgegenhaltungen:
- EP-A- 1 031 929
- WO-A-00/49488
- US-A- 5 598 370
- US-B1- 6 377 500

## Beschreibung

Die Erfindung beschreibt ein Verfahren zur Wiederherstellung der Verwaltungsdatensätze eines sektorweise beschreibbaren und blockweise löschbaren nichtflüchtigen Speichers, die in einem flüchtigen Merkspeicher eines zugehörigen Speichercontrollers geführt werden.

Die weit verbreiteten nichtflüchtigen Halbleiterspeicher (Flashspeicher) sind in Blöcken und in Sektoren organisiert, wobei ein Block z.B. aus 32 Sektoren mit je 512 Bytes besteht. Die Speicher besitzen die Eigenschaft, dass neue Informationen sektorweise geschrieben werden und nur vorher gelöschte Sektoren geschrieben werden können. Das Löschen erfolgt jeweils für einen Block für alle Sektoren gemeinsam. Das Schreiben eines Sektors in den Speicher dauert länger als das Lesen und eine Löschoperation eines Blockes erfordert eine lange Zeit, z.B. mehrere Millisekunden.
Nach einem gleichzeitig hiermit angemeldeten Verfahren werden von einem Programm im zugehörigen Speichercontroller Tabellen in einem schnell zugreifbaren flüchtigen Merkspeicher geführt, in denen jeweils Verwaltungsdatensätze zu den Blöcken und Sektoren verzeichnet sind. Diese Tabellen bestehen im wesentlichen aus Zuordnungen von logischen Blockadressen zu physikalischen Blockadressen und den Adressen von Ausweichblöcken beim Schreiben von Sektoren in den nichtflüchtigen Speicher. Wenn nun der Strom ausfällt, verschwinden die Daten aus dem flüchtigen Merkspeicher. Sie müssten also zu diesem Zeitpunkt in einem Teil des nichtflüchtigen Speichers gesichert enthalten sein, um mit korrekten Daten nach einem Wiederanlauf weiter arbeiten zu können. Dazu ist aber wegen der Dauer der Schreiboperationen beim Stromausfall keine Zeit mehr. Ein ständiges Sichern aller Verwaltungsdatensätze durch Kopien würde jedoch alle Schreiboperationen verlangsamen und zu einer erhöhten Abnutzung des nichtflüchtigen Speichers fuhren.
In der Patentschrift US 5,598,370 ist ein Verfahren zur Sicherung der Verwaltungsdatensätze beschrieben. Hier sind die Informationen über alle Blöcke des Speichers verteilt und es ist ein großer Aufwand erforderlich, die Verwaltungsdaten zu rekonstruieren.
Auch in der Patentschrift US 5 930 193 A ist ein Verfahren beschrieben, die Verwaltungstabellen in einem gesonderten Speicherbereich des nichtflüchtigen Speichers beim Abschalten des Systems abzuspeichern. Dies ist hier aber nur bei einem geordneten Abschalten möglich, bei einem unerwarteten Stromausfall gehen die Verwaltungsdatensätze verloren.
In der europäischen Patentanmeldung EP 1 031 929 A2 ist ebenfalls ein Verfahren beschrieben, Datensätze eines flüchtigen Speichers durch Datensätze in einem nichtflüchtigen Speicher zu sichern und nach einem Stromausfall die Datensätze in chronologischer Reihenfolge zu lesen und so die Daten im flüchtigen Speicher zu rekonstruieren. Dieses Verfahren ist für die Parameter eines elektromechanischen Peripheriegerätes vorgesehen und berücksichtigt nicht die Besonderheiten eines nichtflüchtigen Speichers, der eine Verwaltung von Ausweichspeicherblöcken und deren Reorganisation erfordert.
In der PCT-Anmeldung WO00/49488 ist auch ein Verfahren zur Sicherung der Übersetzungstabelle von logischen Sektoradressen in physikalische Sektoradressen durch eine zusätzliche Adresstabelle beschrieben. Es werden damit aber nicht alle Verwaltungsdaten erfasst, die in einem Speichercontroller aktuell zu halten sind. Dazu sind weitere, aufwendige Verfahren vorgesehen.

Es ist Aufgabe der Erfindung, ein Verfahren zu offenbaren, das es erlaubt, die Verwaltungsdatensätze für einen sektorweise schreibbaren und blockweise löschbaren Speicher in einem schnellen flüchtigen Merkspeicher des zugehörigen Speichercontrollers zu führen und diese Verwaltungsdatensätze bei einem Wiederanlauf nach einem Stromausfall vollständig wiederherzustellen.

Gelöst wird diese Aufgabe dadurch, dass in dem nichtflüchtigen Speicher eine Rekonstruktionstabelle fortlaufend aktualisiert wird, in die Schreib- und Löschoperationen in dem Umfang als Eintrag verzeichnet sind, dass sich die Verwaltungsdatensätze des internen Merkspeichers jeweils bei einem Wiederanlauf nach einem Stromausfall vollständig rekonstruieren lassen.

Vorteilhafte Ausführungsformen sind in den Unteransprüchen angegeben.

Im nichtflüchtigen Speicher werden ein oder mehrere Datenblöcke reserviert, in die eine Rekonstruktionstabelle geschrieben wird. Diese Rekonstruktionstabelle besitzt eine definierte Länge von z.B. 128 Sektoren. Im flüchtigen Merkspeicher werden für die Speicherblöcke, die beschrieben werden, Verwaltungsdatensätze erstellt, in denen unter anderem die logischen und physikalischen Blockadressen vermerkt sind, sowie die Adressen der Ausweichblöcke, in die aktuell geschrieben wird. Werden nun neue Speicherblöcke beschrieben oder neue Ausweichblöcke bereitgestellt und veraltete Zuordnungen von logischen zu physikalischen Blockadressen aufgelöst, wird fortlaufend je ein Eintrag in die Rekonstruktionstabelle geschrieben. Der jeweilige Eintrag in der Rekonstruktionstabelle enthält mindestens die logische Blockadresse, die physikalische Blockadresse des originären Speicherblocks sowie die Adresse des eventuell benutzten Ausweichblocks.
Wenn nun nach einem Stromausfall ein Wiederanlauf des Speichersystems stattfindet, werden vom Programm des Speichercontrollers die Verwaltungsdatensätze im flüchtigen Merkspeicher leer initialisiert und dann die Rekonstruktionstabelle vom Anfang an durchgegangen und die Zuordnungen entsprechend jedes Eintrags in der Rekonstruktionstabelle in die Verwaltungsdatensätze eingetragen. Dies wird für jeden Eintrag in der Rekonstruktionstabelle wiederholt, bis, das Ende dieser Tabelle erreicht ist. Dabei ist es durchaus möglich, dass einige Zuordnungen mehrfach überschrieben werden, da sie auch im Laufe der ursprünglichen Speicherungen aktualisiert wurden. Es wird aber am Ende des Wiederanlaufs der aktuelle Stand der Adresszuordnungen in den Verwaltungsdatensätzen wieder hergestellt, wie er vor dem Stromausfall bestanden hat.

In einer vorteilhaften Ausführung der Rekonstruktionstabelle ist diese so aufgebaut, dass jeder Eintrag in der Tabelle genau einen Sektor lang ist, auch wenn nicht alle Bytes des Sektors gefiillt sind. Da der Speicher immer sektorweise geschrieben wird, ist kein Zusatzaufwand für eine Datenaufbereitung erforderlich. Auch wenn einiger Speicherplatz auf diese Weise nicht genutzt wird, fällt dies bei der Größe des gesamten Speichers nicht ins Gewicht. Da auch alle Sektoren ab dem aktuellen Eintrag in der Tabelle gelöscht sind, wird ohne weiteren Aufwand der nächste Eintrag direkt in die Tabelle geschrieben.

Bei einigen Typen von nichtflüchtigen Speichern ist es auch möglich, nur einen Abschnitt eines Sektors, z.B. von 128 Bytes, unabhängig von den anderen Abschnitten des Sektors zu beschreiben. Bei diesen Typen wird nur ein solcher Abschnitt eines Sektors beschrieben und damit wird beispielsweise nur ein Speicherblock für die Rekonstruktionstabelle benötigt.

Durch den besonderen Aufbau der Rekonstruktionstabelle und die Speicherung dieser Tabelle im nichtflüchtigen Speicher wird erreicht, dass auch während einer Rekonstruktion der Verwaltungsdatensätze der Strom ohne Fehler zu verursachen abermals ausfallen kann. Bei dem erneuten Wiederanlauf des Systems wird nämlich die Rekonstruktionstabelle noch einmal vollständig ausgewertet und damit dann der aktuelle Zustand der Verwaltungsdatensätze erreicht.

Da die Rekonstruktionstabelle eine definierte Länge besitzt, z.B. 128 Einträge, wird sie im normalen Speicherbetrieb bis fast an das Ende gefüllt. Vorteilhafterweise wird, wenn der vorletzte Eintrag geschrieben wurde, wird eine Reorganisation gestartet. Dazu wird ein Vermerk über die Reorganisation als letzter Eintrag in die Rekonstruktionstabelle geschrieben. Dann werden alle Adresszuordnungen, wie sie in den Verwaltungsdatensätzen aktuell aufgeführt sind, aufgelöst und damit ein definierter Grundzustand in den Verwaltungsdatensätzen hergestellt, wie er auch bei einem Wiederanlauf des Systems als erstes initialisiert würde.

Das Verfahren wird weiter verbessert, wenn nach einer erfolgreichen Reorganisation ein Fertig-Eintrag in die Rekonstruktionstabelle geschrieben wird. Dieser Fertig-Eintrag wird vorteilhafterweise mit einem Zählwert versehen, der bei jeder Reorganisation hochgezählt wird.
Weiterhin ist es günstig, bei jeder Reorganisation eine neue Rekonstruktionstabelle in anderen Speicherblöcken anzulegen. Diese werden aus dem Vorrat an gelöschten Speicherblöcken genommen, die entweder noch ursprünglich gelöscht sind oder von einem Hintergrundprogramm gelöscht wurden. Der Fertig-Eintrag wird als erster Eintrag in die neue Rekonstruktionstabelle geschrieben. Die bisherigen Blöcke für die Rekonstruktionstabelle werden dann freigegeben und damit so gekennzeichnet, dass sie von dem Hintergrundprogramm für das Löschen bearbeitet werden.
Falls bei dem Vorgang der Reorganisation der Strom ausfällt und noch kein neuer Fertig-Eintrag geschrieben wurde, wird beim Wiederanlauf des Systems die Reorganisation neu gestartet. Die Reorganisation ist beliebig oft wiederholbar.
Falls der Fertig-Eintrag schon geschrieben wurde, aber die bisherige Rekonstruktionstabelle noch nicht freigegeben wurde, kann es vorkommen, dass bei dem Wiederanlauf des Systems zwei Reorganisationstabellen, die bisherige und die neue, gefunden werden. Dann wird anhand des Zählwertes im Fertig-Eintrag der Rekonstruktionstabelle festgestellt, welches die neuere Tabelle ist,
und der Reorganisationsvorgang wird entsprechend fortgesetzt. Somit wird auch in solchen Fällen das korrekte Weiterarbeiten des Speichersystems sichergestellt.

Bei jeder neuen Adresszuordnung von physikalischen Blockadressen zu logischen Blockadressen müssen die Blockzeiger in der Blockzeigertrabelle entsprechend geändert werden. Diese Blockzeigertabelle steht im nichtflüchtigen Speicher und das Schreiben der Änderungen müsste jedes Mal über den Ausweichblockmechanismus laufen. Um die Schreiboperationen zu optimieren, wird im flüchtigen Merkspeicher eine Zeigerzwischentabelle gehalten, in der die geänderten Adresszuordnungen mit der logischen Blockadresse und der geänderten physikalischen Blockadresse festgehalten werden. Diese Tabelle ist nach logischen Blockadressen geordnet. Falls nun eine Adresszuordnung durchgeführt wird, wird zunächst in dieser Zeigerzwischentabelle nachgesehen, ob die logische Blockadresse dort verzeichnet ist. Wenn dies der Fall ist , wird die dort angegebene physikalische Speicherblockadresse benutzt, ansonsten wird die physikalische Speicherblockadresse aus der Blockzeigertabelle benutzt.
Die Zeigerzwischentabelle gibt somit an, welche Einträge in der Blockzeigertabelle nicht mehr gültig sind. Bei der vorstehend beschriebenen Reorganisation werden auch die Blockzeigertabellen im nichtflüchtigen Speicher neu geschrieben und mit den Werten aus der Zeigeizwischentabelle aktualisiert. Somit werden die Änderungen der Blockzeiger nur bei der Reorganisation neu in den nichtflüchtigen Speicher geschrieben und damit eine große Anzahl von Schreiboperationen eingespart.
Bei einem Stromausfall geht die Zeigerzwischentabelle verloren. Da jede neue Adresszuordnung mit ihren logischen und physikalischen Blockadressen seit der letzten Reorganisation in der Rekonstruktionstabelle als Eintrag gespeichert ist, wird auch die Zeigerzwischentabelle bei einem Wiederanlauf des Systems mit rekonstruiert.

Die Ausgestaltung der Erfindung ist in den Figuren beispielhaft beschrieben.
Fig. 1 zeigt den Aufbau einer Rekonstruktionstabelle
Fig. 2 zeigt den Zusammenhang der Zwischenzeigertabelle mit der Blockzeigertabelle

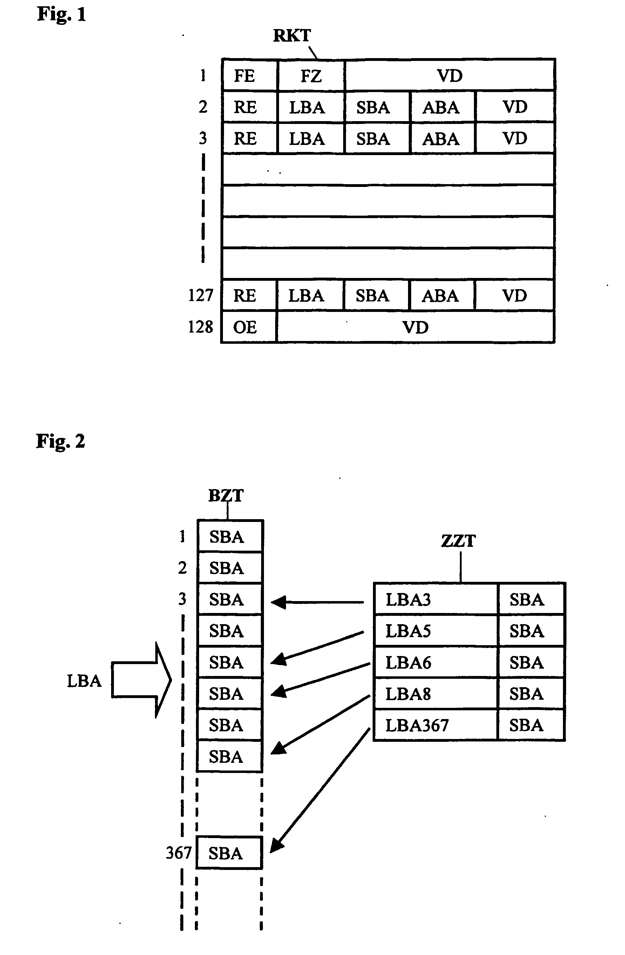

In der Fig. 1 ist der Aufbau der Rekonstruktionstabelle RKT dargestellt. Sie besteht hier aus 128 Einträgen, die jeweils einen Sektor lang sind. Der erste Eintrag ist als Fertig-Eintrag FE gekennzeichnet und enthält außerdem auch den Fertigzähler FZ. Es ist Platz für weitere Verwaltungsdaten VD. Ab dem zweiten Eintrag sind Rekonstruktionseinträge RE verzeichnet, die aus den gemerkten Schreiboperationen die Einträge für die logischen Blockadressen LBA. die physikalischen Speicherblockadressen SBA, die benutzten Ausweichblockadressen ABA sowie weitere Verwaltungsdaten VD enthalten. Der letzte Eintrag in der Rekonstruktionstabelle RKT wird als Reorganisationseintrag OE gekennzeichnet. Auch er hat Platz für weitere Verwaltungsdaten VD.

In der Fig. 2 ist die Blockzeigertabelle BZT dargestellt, die mit der logischen Blockadresse LBA indiziert ist und jeweils die zugehörige physikalische Speicherblockadresse SBA enthält. Diese Tabelle BZT steht im nichtflüchtigen Speicher. Im flüchtigen Merkspeicher ist die Zeigerzwischentabelle ZZT aufgebaut, die in jeder Tabellenzeile eine Zuordnung von logischen Blockadressen LBA zu physikalischen Speicherblockadressen SBA enthält. Dies sind die logischen Blockadressen LBA, deren Zuordnung zu physikalischen Speicherblockadressen SBA sich seit der letzten Reorganisation geändert haben. Die Tabellenzeilen sind nach aufsteigenden logischen Blockadressen LBAn sortiert und geben die Einträge in der Blockzeigertabelle BZT an, die nicht mehr gültig sind und bei der nächsten Reorganisation aktualisiert werden. szeichen
- ABA: Ausweichblockadresse
- BZT: Blockzeigertabelle
- FE: Fertig-Eintrag
- FZ: Fertig-Zähler
- LBA: Logische Blockadresse
- LBAn: Logische Blockadresse n in der ZZT
- OE: Reorganisationseintrag
- RE: Rekonstruktionseintrag
- RKT: Rekonstruktionstabelle
- SBA: Speicherblockadresse
- VD: Verwaltungsdaten
- ZZT: Zeigeizwischentabelle

## Patentansprüche

1. Verfahren zur Wiederherstellung von Verwaltungsdatensätzen eines sektorweise beschreibbaren und blockweise löschbaren nichtflüchtigen Speichers, die in einem schneller zugreifbaren internen flüchtigen Merkspeicher eines zugehörigen Speichercontrollers gehalten werden wobei in einem oder mehreren Speicherblöcken des nichtflüchtigen Speichers eine zusammenhängende Rekonstruktionstabelle (RKT) fortlaufend aktualisiert wird, in der alle Schreib- und Löschoperationen im nichtflüchtigen Speicher in dem Umfang als Eintrag verzeichnet sind, so dass sich die Verwaltungsdatensätze des internen Merkspeichers des Speichercontrollers jeweils bei einem Wiederanlauf nach einem Stromausfall vollständig rekonstruieren lassen, **dadurch gekennzeichnet, dass** jeweils bei Erreichen eines vordefinierten Füllstandes der Rekonstruktionstabelle (RKT) eine Reorganisation zur Herstellung eines definierten Grundzustands der Verwaltungsdatensätze im Merkspeicher und in der Rekonstruktionstabelle (RKT) gestartet wird, und dass dieser Start der Reorganisation als letzter Eintrag (OE) in der Rekonstruktionstabelle (RKT) vermerkt wird.

2. Verfahren nach Anspruch 1, **dadurch gekennzeichnet, dass** jeder Eintrag in die Rekonstruktionstabelle (RKT) einen Sektor oder einen Sektorabschnitt lang ist.

3. Verfahren nach Anspruch 1, **dadurch gekennzeichnet, dass** die Rekonstruktion der Verwaltungsdatensätze des Merkspeichers wiederholt wird, wenn bei der Rekonstruktion der Datensätze der Strom abermals ausgefallen war.

4. Verfahren nach Anspruch 1, **dadurch gekennzeichnet, dass** jedes Mal wenn die Reorganisation erfolgreich war ein Fertig-Eintrag (FE) in der Rekonstruktionstabelle erfolgt, der einen Zähler (FZ) enthält, der bei jedem Fertig-Eintrag hochgezählt wird.

5. Verfahren nach Anspruch 4, **dadurch gekennzeichnet, dass** zum erneuten Einrichten der Rekonstruktionstabelle (RKT) nach einer erfolgreichen Reorganisation die bisher genutzten Speicherblöcke zum Löschen in einem Hintergrundprogramm freigegeben und ein noch gelöschte Blöcke entsprechend initialisiert werden.

6. Verfahren nach Anspruch 5, **dadurch gekennzeichnet, dass** der erste Eintrag in einer Rekonstruktionstabelle (RKT) ein Fertig-Eintrag (FE) ist.

7. Verfahren nach Anspruch 1, **dadurch gekennzeichnet, dass** als Teil der Verwaltungsdatensätze im Merkspeicher eine Tabelle (ZZT) für jeweils ungültige Blockzeiger geführt wird, die in einer Blockzeigertabelle (BZT) im nichtflüchtigen Speicher enthalten sind.

8. Verfahren nach Anspruch 3, **dadurch gekennzeichnet, dass** jeweils bei der Reorganisation die Blockzeigertabelle (BZT) anhand der Tabelle (ZZT) für ungültige Blockzeiger aktualisiert wird.

## Claims

1. A method for restoring administrative data records of a nonvolatile memory that can be written in units of sectors and erased in units of blocks, said records being stored in a more rapidly accessible internal volatile flag memory of an associated memory controller, wherein in one or more memory blocks of the nonvolatile memory a reconstruction table (RKT) is continually updated in which all write and erase operations in the nonvolatile memory are recorded as an entry to such an extent that the administrative data records of the internal flag memory of the memory controller can be completely reconstructed in each case during a restart after a power failure, **characterized in that** when a predefined fill level of the reconstruction table (RKT) is reached, a reorganization is started in each case to create a defined initial state of the administrative data records in the flag memory and in the reconstruction table (RKT) and that this start of the reorganization is recorded as the last entry (OE) in the reconstruction table (RKT).

2. A method according to claim 1, **characterized in that** every entry in the reconstruction table (RKT) is one sector or one sector segment long.

3. A method according to claim 1, **characterized in that** the reconstruction of the administrative data records of the flag memory is repeated if another power failure has occurred during the reconstruction of the data records.

4. A method according to claim 1, **characterized in that** every time the reorganization was successful, a completion entry (FE) takes place in the reconstruction table, said completion entry containing a counter (FZ), which is incremented with every completion entry.

5. A method according to claim 4, **characterized in that** for the renewed creation of the reconstruction table (RKT) after a successful reorganization, the previously used memory blocks are released for erasing in a background program and still erased blocks are initialized accordingly.

6. A method according to claim 5, **characterized in that** the first entry in a reconstruction table (RKT) is a completion entry (FE).

7. A method according to claim 1, **characterized in that**, as a portion of the administrative data records, a table (ZZT) is maintained in the flag memory for any invalid block pointers that are contained in a block pointer table (BZT) in the non-volatile memory.

8. A method according to claim 3, **characterized in that** during the reorganisation the block pointer table (BZT) is updated in each case with the aid of the table (ZZT) for invalid block pointers.

## Revendications

1. Méthode pour reconstituer des enregistrements administratifs d'une mémoire non-volatile sur laquelle les donnés sont enregistrées par secteurs et effacées par blocs, lesdits enregistrements administratifs étant mises dans une mémoire volatile interne d'un contrôleur de mémoire associé, celle-ci étant plus rapidement accessible ; et une table de reconstruction (RKT) contigu, dans un ou plusieurs blocs de la mémoire non-volatile, étant mise à jour continuellement, dans laquelle tous opérations d'enregistrement et d'effacement effectuées dans la mémoire non-volatile sont enregistrées à un tel point que les enregistrements administratifs de la mémoire volatile interne du contrôleur de mémoire peuvent être complètement reconstitués dans le cas d'une reprise après une panne de courant, **caractérisée en ce que** quand un niveau de remplissage prédéfini de la table de reconstruction (RKT) est atteint, une réorganisation est commencée dans chaque cas pour créer un état initial défini des enregistrements administratifs dans la mémoire volatile et dans la table de reconstruction (RKT), et que ce début de la réorganisation est enregistré comme dernier enregistrement (OE) dans la table de reconstruction (RKT).

2. Méthode selon la revendication 1, **caractérisée en ce que** chaque enregistrement dans la table de reconstruction (RKT) est long d'un secteur ou d'un segment de secteur.

3. Méthode selon la revendication 1, **caractérisée en ce que** la reconstruction des enregistrements administratifs de la mémoire volatile est répétée si une autre panne de courant s'est produite pendant la reconstruction des enregistrements.

4. Méthode selon la revendication 1, **caractérisée en ce que**, chaque fois que la réorganisation est réussie, un enregistrement d'accomplissement (FE) est fait dans la table de reconstruction, ledit enregistrement d'accomplissement contenant un compteur (FZ), qui est incrémenté avec chaque enregistrement d'accomplissement.

5. Méthode selon la revendication 4, **caractérisée en ce que**, pour recréer la table de reconstruction (RKT) après une réorganisation réussie, les blocs de mémoire précédemment utilisés sont libérés pour l'effacement dans un programme du fond et des blocs toujours effacés sont initialisés de manière correspondante.

6. Méthode selon la revendication 5, **caractérisée en ce que** le premier enregistrement dans une table de reconstruction (RKT) est un enregistrement d'accomplissement (FE).

7. Méthode selon la revendication 1, **caractérisée en ce qu'**une table (ZZT) pour les indicateurs de bloc périmés fait partie des enregistrements administratifs dans la mémoire volatile, lesdits indicateurs étant contenus dans une table d'indicateurs de bloc (BZT) dans la mémoire non-volatile.

8. Méthode selon la revendication 3, **caractérisée en ce que** la table d'indicateurs de bloc (BZT) est mise à jour pendant chaque réorganisation, à l'aide de la table (ZZT) pour les indicateurs de bloc périmés.
